(19) Europäisches Patentamt / European Patent Office / Office européen des brevets

(11) **EP 2 950 354 A1**

(12) **EUROPEAN PATENT APPLICATION**

(43) Date of publication:
02.12.2015 Bulletin 2015/49

(51) Int Cl.:
*H01L 33/06* (2010.01) *H01L 33/30* (2010.01)
*H01S 5/343* (2006.01) *H01L 33/00* (2010.01)

(21) Application number: 15001540.2

(22) Date of filing: 21.05.2015

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA

(30) Priority: 29.05.2014 JP 2014111011

(71) Applicant: **Canon Kabushiki Kaisha Tokyo (JP)**

(72) Inventor: **Sekiguchi, Yoshinobu Ohta-ku, Tokyo (JP)**

(74) Representative: **WESER & Kollegen Radeckestraße 43 81245 München (DE)**

(54) **SEMICONDUCTOR LIGHT EMITTING ELEMENT AND OPTICAL COHERENCE TOMOGRAPHY APPARATUS**

(57) The semiconductor light emitting element, includes a multiple quantum well active layer including a first quantum well (141) and a second quantum well (142) having well widths different from each other. Well layers of the first quantum well (141) and the second quantum well (142) are formed of $In_xGa_{1-x}As$. A well width Lw and a well layer In content $In_x(Lw)$ of the first quantum well (141), and a well width Ln and a well layer In content $In_x(Ln)$ of the second quantum well (142) satisfy the following Expression (1): $0.0631(Ln/Lw)^2 - 0.134(Ln/Lw) + 0.0712 < In_x(Ln) - In_x(Lw) < 0.0068(Ln/Lw)^2 - 0.1995(Ln/Lw) + 0.192$ (1).

EP 2 950 354 A1

# EP 2 950 354 A1

**Description**

BACKGROUND OF THE INVENTION

Field of the Invention

The present invention relates to a semiconductor light emitting element, a superluminescent diode having a wide spectrum band, and a semiconductor optical amplifier. The present invention also relates to an optical coherence tomography apparatus using the semiconductor light emitting element.

Description of the Related Art

An optical coherence tomography apparatus using optical coherence tomography (OCT) measurement, which is hitherto used in acquiring an optical tomography image of living tissue, splits low coherent light emitted from a light source into measurement light and reference light. After that, light reflected from an object to be measured when the measurement light is radiated to the object to be measured and the reference light are composited. In accordance with intensities of coherent light of the reflected light and the reference light, an optical tomography image is acquired.

When a superluminescent diode (SLD) is used as the light source of such an imaging device, a wide-band spectrum is desired as an emission spectrum of the SLD. To form a plurality of quantum well layers having different emission wavelengths is a method of realizing such a wide-band spectrum.

In Japanese Patent Application Laid-Open No. 2009-283736, it is disclosed that, by using an active layer having a multiple quantum well structure (hereinafter sometimes simply referred to as multiple quantum well active layer) that includes a plurality of different quantum wells having well widths of 2 nm to 6 nm, a wide-band emission spectrum is realized.

However, an active layer having an asymmetric quantum well structure that includes a quantum well having a well width A and a quantum well having a smaller well width (hereinafter sometimes simply referred to as asymmetric quantum well active layer) has a smaller sum total of the well widths than that of a symmetric quantum well active layer that includes two identical quantum wells each having the well width A, and thus, a capture cross-sectional area of carriers is smaller and emission intensity is lower. In addition, the present inventors have found that an energy band bends in proximity to the two quantum wells of the asymmetric quantum well active layer. -The- energy band bends, and thus, amounts of carriers injected into the respective quantum wells are nonuniform, which further lowers emission efficiency.

SUMMARY OF THE INVENTION

Accordingly, the present invention is directed to proving a semiconductor light emitting element in which, by appropriately selecting a band gap of a well layer with regard to each of quantum wells having different well widths of an asymmetric quantum well active layer, an energy band in proximity to the quantum wells is brought close to a flat state, carrier injection into each of the quantum wells is optimized, and the emission efficiency can be improved.

The present invention is also directed to providing an optical coherence tomography apparatus that can perform observation with high resolution in a depth direction by using the semiconductor light emitting element in a light source portion thereof.

According to one aspect of the present invention, there is provided a semiconductor light emitting element, including a multiple quantum well active layer including a first quantum well and a second quantum well having well widths different from each other.

The first quantum well has a larger well width than the second quantum well and is formed of a material having a wider well layer band gap.

Well layers of the first quantum well and the second quantum well are formed of $In_xGa_{1-x}As$, and a well width Lw and a well layer In content $In_x$ (Lw) of the first quantum well, and a well width Ln and a well layer In content $In_x$ (Ln) of the second quantum well satisfy the following Expression (1):

$$0.0631(Ln/Lw)^2 - 0.134(Ln/Lw) + 0.0712 < In_x(Ln) - In_x(Lw)$$

$$< 0.006(Ln/Lw)^2 - 0.1995(Ln/Lw) + 0.192 \qquad (1).$$

Further, according to another aspect of the present invention, there is provided an optical coherence tomography apparatus, including:

2

a light source portion using the above-mentioned semiconductor light emitting element;

an object measuring portion for radiating light from the light source portion to an object and for transmitting reflected light from the object;

a reference portion for radiating light from the light source portion to a reference mirror and for transmitting reflected light from the reference mirror;

a coherence portion for achieving coherence between reflected light from the object measuring portion and reflected light from the reference portion;

an optical detection portion for detecting coherent light from the coherence portion; and

an image processing portion for acquiring a tomography image of the object based on light detected by the optical detection portion.

Further features of the present invention will become apparent from the following description of exemplary embodiments with reference to the attached drawings.

BRIEF DESCRIPTION OF THE DRAWINGS

FIG. 1 is an energy band diagram of an active layer portion for illustrating an embodiment of the present invention.

FIG. 2 is a graph for showing a relationship among an optical output of an SLD, and a well width and an In content of a well layer of a second quantum well in Example 1 of the present invention.

FIGS. 3A and 3B are a band diagram and a graph for showing an electron concentration distribution in proximity to the active layer for illustrating the embodiment of the present invention.

FIGS. 4A and 4B are a band diagram and a graph for showing an electron concentration distribution in proximity to the active layer for illustrating the embodiment of the present invention.

FIGS. 5A and 5B are a band diagram and a graph for showing an electron concentration distribution in proximity to the active layer for illustrating a comparative example of the present invention.

FIG. 6A is a graph for showing a relationship between the In content and the well width of the second quantum well for illustrating Example 1 of the present invention and FIG. 6B is a graph in which the horizontal axis in FIG. 6A is converted to Ln/Lw.

FIG. 7 is a graph for showing a relationship between the optical output and the In content of the well layer of the second quantum well for illustrating Example 1 of the present invention.

FIG. 8A is a graph showing a fitted curve of the maximum In content difference $\Delta In_x$ and a fitted curve of the minimum In content difference $\Delta In_x$, FIG. 8B is a graph for showing ranges of a well width Ln and an In content of the well layer of $In_xGa_{1-x}As$ of the second quantum well, and FIG. 8C is a graph showing a fitted curve of the maximum In content difference $\Delta In_x$ and a fitted curve of the minimum In content difference $\Delta In_x$.

FIG. 9 is a sectional view for illustrating a structure of the SLD of Example 1 of the present invention.

FIG. 10 is a perspective view of the SLD of Example 1 of the present invention.

FIG. 11 is a perspective view of an SLD having a two electrode structure of Example 1 of the present invention.

FIGS. 12A and 12B are graphs for showing relationships between an optical output and an Al content of a well layer of a second quantum well of Example 2 of the present invention.

FIG. 13 is a graph for showing a relationship between a well layer Al content difference and a well width ratio of Example 2 of the present invention.

FIGS. 14A, 14B, 14C and 14D are graphs for showing change in emission profile of Example 1 of the present invention.

FIG. 15 is a graph for showing a structure of a 2QW active layer with which a wide-band emission profile is obtained of Example 3 of the present invention.

FIG. 16 is a graph for showing a range of the 2QW active layer with which the wide-band emission profile is obtained of Example 3 of the present invention.

FIG. 17 is a graph for showing a characteristic that increase in emission intensity of a 3QW active layer of Example 4 of the present invention depends on an In content of a second quantum well.

FIG. 18 is a graph for showing a characteristic that increase in emission intensity of the 3QW active layer of Example 4 of the present invention depends on an In content of a third quantum well.

FIG. 19 is a graph for showing a characteristic that increase in emission intensity of a 3QW active layer of another structure of Example 4 of the present invention depends on the In content of the second quantum well.

FIG. 20 is a graph for showing a characteristic that increase in emission intensity of a 3QW active layer of still another structure of Example 4 of the present invention depends on the In content of the third quantum well.

FIGS. 21A and 21B are graphs for showing current/optical output characteristics and an emission profile, respectively, of a structure of the 2QW active layer with which a wide-band emission profile is obtained of Example 3 of the present invention.

FIGS. 22A and 22B are graphs for showing current/optical output characteristics and an emission profile, respectively, of a structure of a 3QW active layer with which a wide-band emission profile is obtained of Example 5 of the present invention.

FIGS. 23A, 23B and 23C are graphs for showing wide-band emission profiles, respectively, of the 3QW active layer of other structures of Example 5 of the present invention.

FIG. 24A is a graph for showing dependence of an optical output on a well width of a third quantum well and an In content with regard to conditions under which a wide-band emission profile is obtained in a 3QW active layer of Example 5 of the present invention.

FIG. 24B is a graph for showing dependence of an optical output on the well width of the third quantum well and an In content with regard to conditions under which a wide-band emission profile is obtained in another 3QW active layer of Example 5 of the present invention.

FIG. 25 is a block diagram in which a semiconductor light emitting element according to the present invention is applied to a light source portion of an optical coherence tomography apparatus.

DESCRIPTION OF THE EMBODIMENT

An embodiment of the present invention is described in the following with reference to the attached drawings. It is to be noted that the present invention is not limited to the following embodiment.

In the following embodiments and examples, a calculation result of a property of a semiconductor light emitting element (light output intensity, electron density distribution, energy band diagram) was obtained by use of PICS3D (Photonic Integrated Circuit Simulator in 3D) (manufactured by Crosslight Software Inc.). Further, the calculations were performed in "Mixed mode".

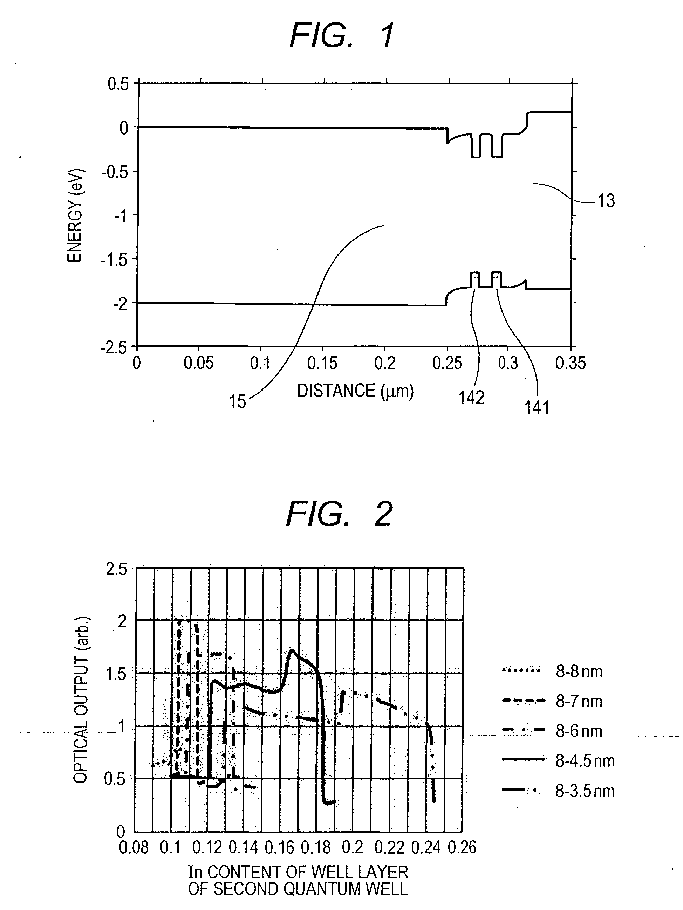

FIG. 1 is an energy band diagram of an active layer portion of a semiconductor light emitting element. The semiconductor light emitting element has a multiple quantum well active layer including a first quantum well 141 and a second quantum well 142. The two quantum wells are different in that the first quantum well 141 is formed of a material having a wider well layer band gap and has a larger well width than those of the second quantum well 142. Like reference numerals are used to denote like components throughout the energy band diagrams referred to below. It is to be noted that each of the first quantum well 141 and the second quantum well 142 has a barrier layer formed therein that is thick enough for an intrinsic quantum level to be formed therein.

An asymmetric quantum well active layer is used in a device that requires a wide emission spectrum. However, when one of the quantum wells is narrowed, a total well width is smaller than that of a symmetric double quantum well active layer in which two quantum wells both having the larger well width are laminated, and thus, it is said that a capture cross-sectional area of carriers is smaller and emission intensity is lower.

FIG. 2 is dependence of an optical output of a superluminescent diode, which has asymmetric quantum wells as an active layer, on an In content of a well layer of a second quantum well.

FIG. 2 is a relative optical output when the first quantum well of $In_{0.1}Ga_{0.9}As$ has a well width of 8 nm and the second quantum well has a well width of 7 nm, 6 nm, 4.5 nm, and 3.5 nm. When a well layer of the first quantum well has a well width of L1 and a well layer of the second quantum well has a well width of L2, the combination is referred to as "L1-L2 nm", and the same applies to similar graphs referred to below. With regard to the respective well widths of the second quantum well, an In content region of the well layer of $In_xGa_{1-x}As$ in which the optical output is increased twice or more exists.

As comparison data, a relative optical output of a symmetric double quantum well active layer is also shown in FIG. 2, in which two well layers of $In_{0.1}Ga_{0.9}As$ having a well width of 8 nm are laminated. A structure having a maximum relative optical output is limited to a well in which an In content of $In_xGa_{1-x}As$ is 0.1.

The increased optical output when the asymmetric double quantum well active layer has a well width of 7 nm, 6 nm, and 4.5 nm is larger than the optical output of the symmetric double quantum well active layer having a well width of 8 nm.

As shown in FIG. 2, a light output intensity obtained by using a quantum well (Lw=8nm, Ln=4.5nm, 6nm, 7nm and a specific range of Indium composition) is larger than a light output intensity obtained by using a quantum well (Lw,Ln=8nm).

Incidentally, a light output intensity obtained by using a quantum well(Lw=8nm, Ln=3.5nm and an appropriate range of Indium composition) is large. On the other hand, a light output intensity obtained by using a quantum well (Lw=8nm, Ln=4,5nm, 6nm, 7nm) is large in a wide range of Indium composition. In other words, even if an Indium composition is different from the design value by an accident error, it is easy to increase a light output intensity. Thus, the degree of freedom of designing an Indium composition is high.

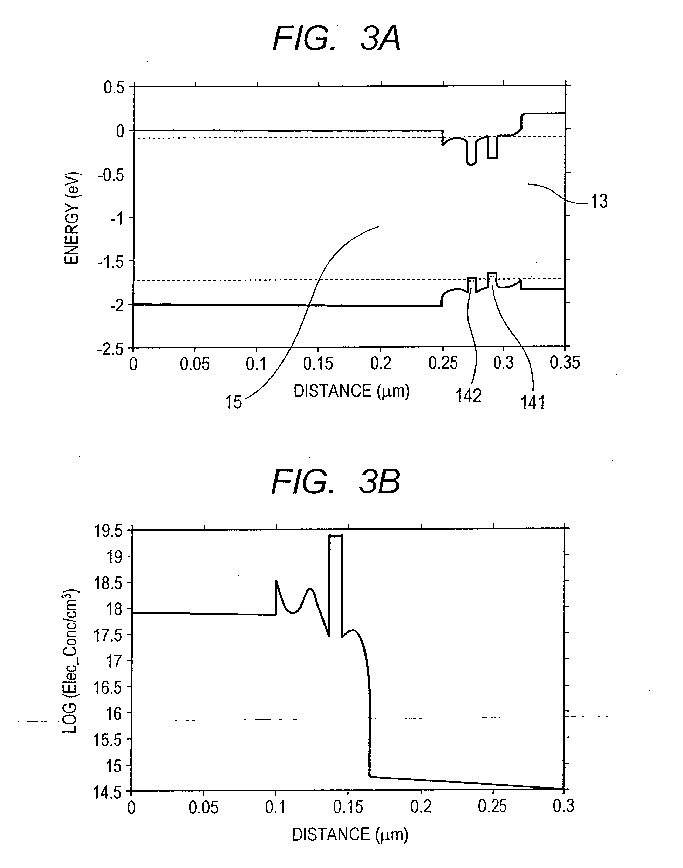

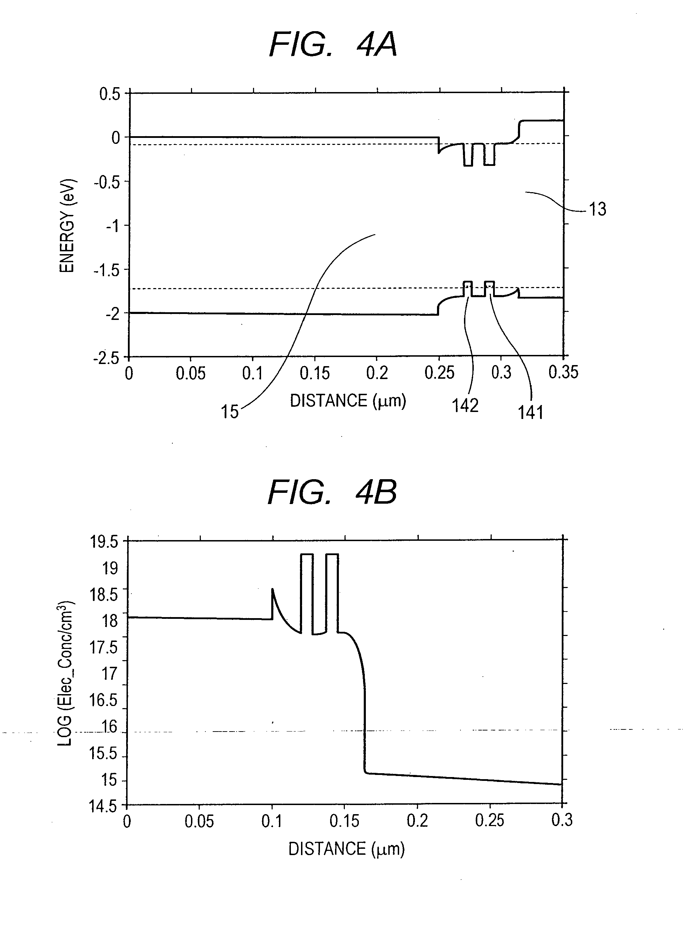

FIGS. 3A and 3B are an energy band diagram and a graph for showing an electron concentration distribution in proximity to the active layer when the quantum well structure is designed so that the optical output is reduced. The asymmetric double quantum well active layer includes a well having a larger well width of 8 nm ($In_{0.1}Ga_{0.9}As$) and a well having a smaller well width of 7 nm ($In_{0.1}Ga_{0.9}As$) . The energy band bends in a barrier layer between the two quantum wells, and the narrower well has a considerably low electron concentration. On the other hand, FIGS. 4A and 4B are an energy band diagram and a graph for showing an electron concentration distribution in proximity to the active layer when the quantum well structure is designed so that the optical output is increased. The asymmetric double quantum well active layer includes the first quantum well having a well width of 8 nm ($In_{0.1}Ga_{0.9}As$) and the second quantum well having a well width of 7 nm ($In_{0.11}Ga_{0.89}As$). The energy band between the two quantum wells is flat, and the electron concentration distributions in the two quantum wells are almost the same.

Such a quantum well structure increases the capture cross-sectional area of the carriers and increases the optical output.

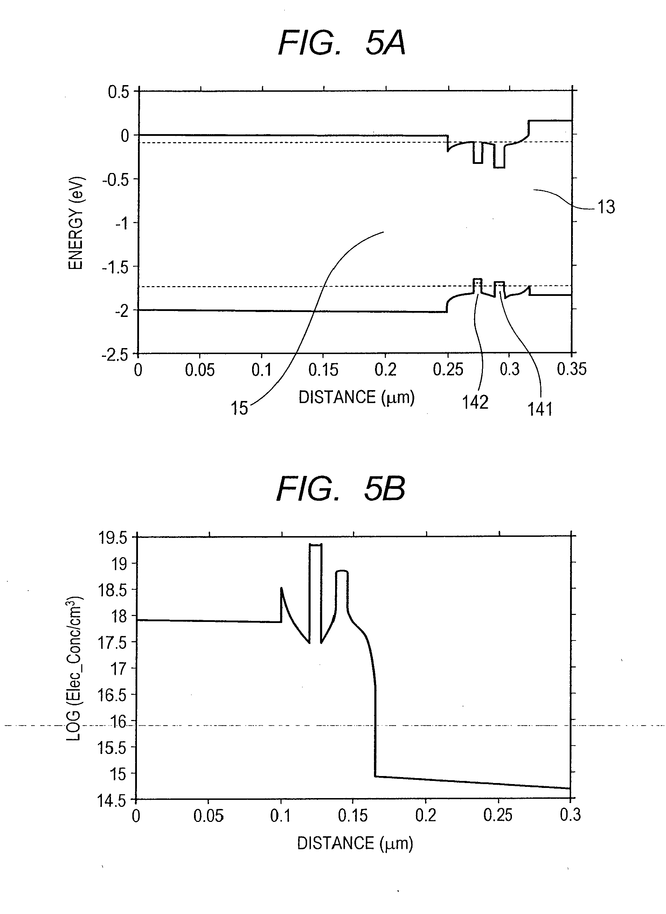

FIGS. 5A and 5B are an energy band diagram and a graph for showing an electron concentration distribution in proximity to the active layer of a comparative example as a symmetric double quantum well active layer having a well width of 8 nm ($In_{0.1}Ga_{0.9}As$) when the optical output is at the maximum. Although the same quantum well structures are laminated, the energy band bends in the barrier layer between the two quantum wells, and one of the wells has a low electron concentration. Specifically, in the symmetric double quantum well active layer in which the same quantum wells are laminated, the energy band bends in proximity to the quantum wells, and the two quantum wells have different carrier concentrations.

Even in the case of an asymmetric double quantum well active layer having a small total well width, if the energy band is flat in proximity to the two quantum wells, the optical output is larger than that of a symmetric double quantum well active layer. In the semiconductor light emitting element according to this embodiment, with regard to such an asymmetric quantum well structure having two quantum wells, an optimum range is defined as a combination of a composition of the well layer and the well width so that the energy band between the two quantum wells is flat. By adopting the optimum range of a combination of a composition of the well layer and the well width, a semiconductor light emitting element having a large optical output can be realized. Further, by selecting a specific range, a width of an emission band can be increased. The optimum range is described in detail in the following.

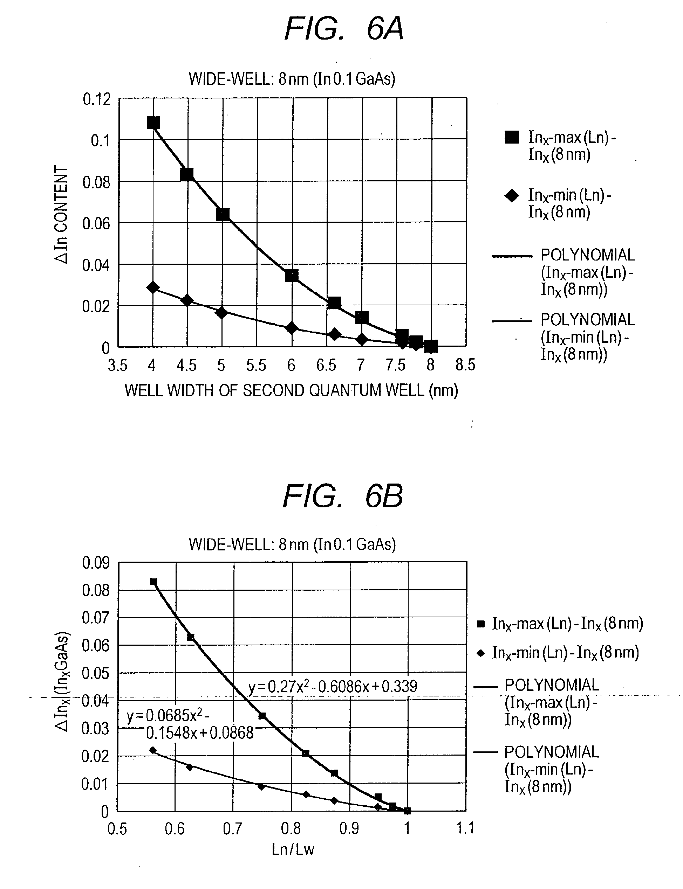

FIG. 6A is a graph for showing ranges of a well width Ln and an In content of the well layer of $In_xGa_{1-x}As$ of the second quantum well with which the asymmetric double quantum well active layer having a well width of the first quantum well of 8 nm and a well width of the second quantum well of 4.5 nm to 7.8 nm has a larger optical output than that of a symmetric double quantum well active layer having a well width of 8 nm. With regard to the well width Ln of the second quantum well, a minimum value and a maximum value of the In content of the second quantum well layer with which the optical output is larger than that of the symmetric double quantum well active layer having a well width of 8 nm are denoted as $In_x$-min (Ln) and $In_x$-max(Ln), respectively. An In content difference $\Delta Inx$ is obtained by subtracting an In content $In_x(Lw)$ of the well layer of the first quantum well Lw from each of the maximum value and the minimum value, In FIG. 6A, a minimum difference $\Delta In_x$ $In_x$-min(Ln)-$In_x$(Lw) and a maximum difference $\Delta In_x$ $In_x$-max(Ln)-$In_x$(Lw) are plotted as a function of the width Ln of the second quantum well.

Fitted curves of the minimum In content difference $\Delta In_x$ $In_x$-min(Ln)-$In_x$(Lw) and the maximum In content difference $\Delta In_x$ $In_x$-max(Ln)-$In_x$(Lw) with regard to various widths Ln of the second quantum well are referred to as a minimum fitted curve and a maximum fitted curve, respectively. In FIG. 6A, with regard to various widths Ln of the second quantum well, when the In content difference $\Delta In_x$ is between the minimum fitted curve and the maximum fitted curve, the asymmetric double quantum well active layer has a larger optical output than that of the symmetric double quantum well active layer in which two layers having a well width of 8 nm are laminated.

FIG. 6B is a graph in which the horizontal axis in FIG. 6A is converted to Ln/Lw (Ln: the width of the second quantum well; Lw: the width of the first quantum well).

Such an output increase characteristic is obtained also by using an asymmetric double quantum well activity layer whose width of the first quantum well is not 8 nm.

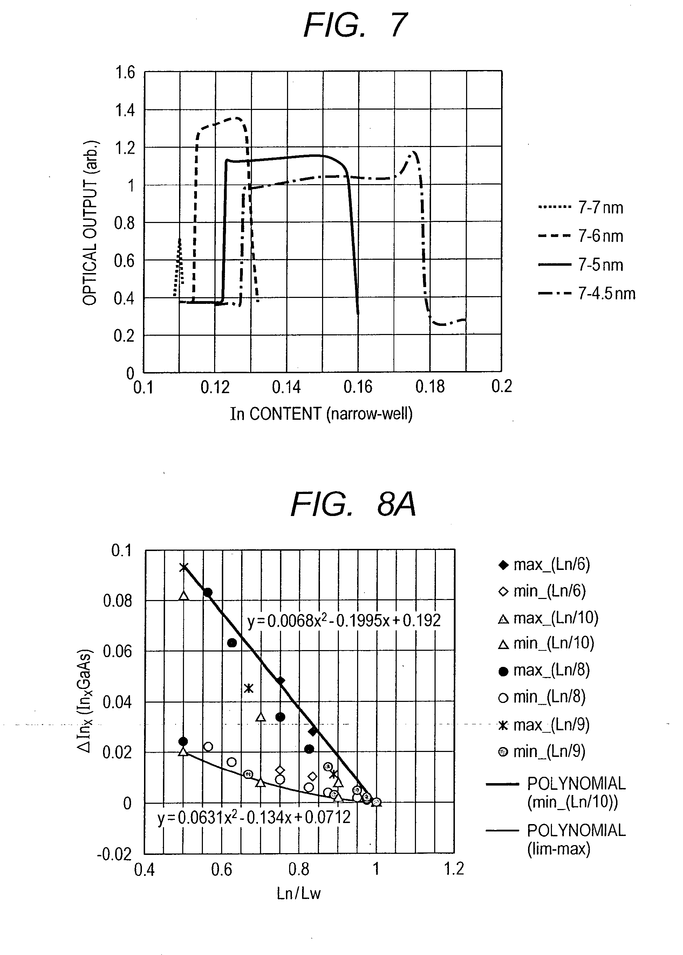

FIG. 7 is a graph which shows a property of optical output intensity obtained by using an asymmetric double quantum well activity layer whose width of the first quantum well is 7 nm. As shown in FIG. 7, a light output intensity obtained by using a quantum well (Ln=6 nm, 5 nm, 4.5 nm) is larger than a light output intensity obtained by using a symmetric double quantum well(Lw,Ln=7 nm).

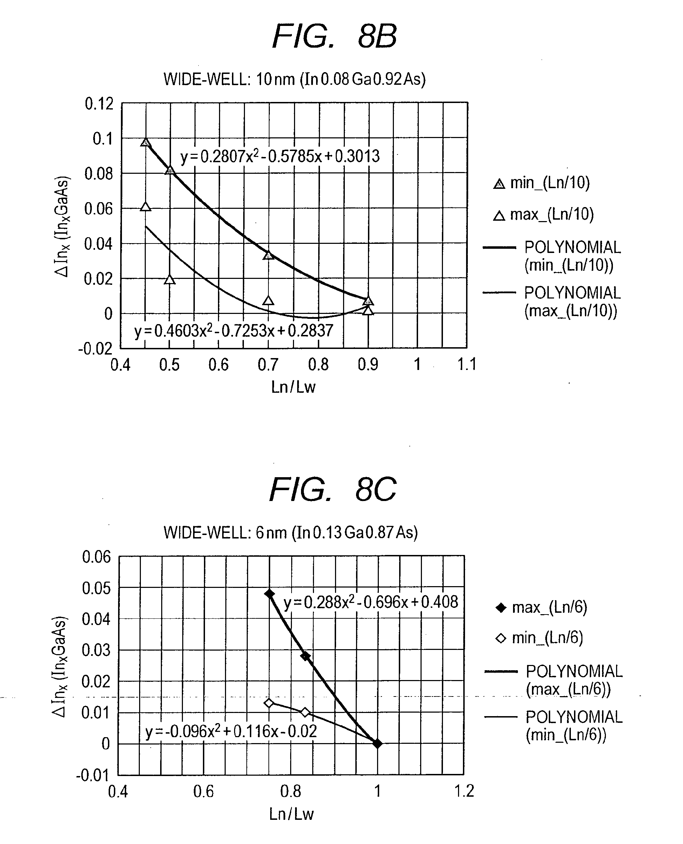

FIG. 8B is a graph for showing ranges of a well width Ln and an In content of the well layer of $In_xGa_{1-x}As$ of the second quantum well with which the asymmetric double quantum well active layer having a well width of the first quantum well of 10 nm (In0. 08Ga0.92As) and a well width of the second quantum well of 4.5 nm or more and Ln/Lw>1/2 has a larger optical output than that of a symmetric double quantum well active layer having a well width of 8 nm.

With regard to the well width Ln of the second quantum well, a minimum value and a maximum value of the In content of the second quantum well layer with which the optical output is larger than that of the symmetric double quantum well active layer having a well width of 10 nm are represented by $In_x$-min (Ln) and $In_x$-max (Ln), respectively. An In content difference $\Delta In_x$ is obtained by subtracting an In content $In_x$ (Lw) of the well layer of the first quantum well Lw from each of the maximum value and the minimum value. In FIG. 6A, a minimum difference $\Delta In_x$ $In_x$-min (Ln)-$In_x$ (Lw)

and a maximum difference $\Delta In_x$ $In_x$-max(Ln)-$In_x$(Lw) are plotted as a function of the width Ln of the second quantum well. FIG. 8C is the same as FIG. 8B except for Ln=6nm. FIG. 8A compiled FIG. 6B, FIG. 8B and FIG. 8C.

In FIG. 8A, a fitted curve of the maximum In content difference $\Delta In_x$ and a fitted curve of the minimum In content difference $\Delta In_x$ are depicted.

With regard to an arbitrary value of Ln/Lw, when the In content difference $\Delta In_x$ is between the maximum fitted curve and the minimum fitted curve, that is, when the In content difference $\Delta In_x$ satisfies Expression (1) that expresses the fitted curves in mathematical form, an optical output that is larger than that of the symmetric double quantum well active layer in which two first quantum wells having the well width Lw are laminated can be obtained.

$$0.0631(Ln/Lw)^2 - 0.134(Ln/Lw) + 0.0712 < In_x(Ln) - In_x(Lw)$$

$$< 0.0068(Ln/Lw)^2 - 0.1995(Ln/Lw) + 0.192 \qquad (1)$$

It is to be noted that in this embodiment, a structure is described in which the first quantum well having the larger well width is arranged on a p-doped side in the active layer, but similar characteristics can be obtained when the first quantum well is arranged on an n-doped side.

[Examples]

In the following, Examples are represented to describe the present invention in detail, but the scope of the present invention is not limited thereto.

[Example 1]

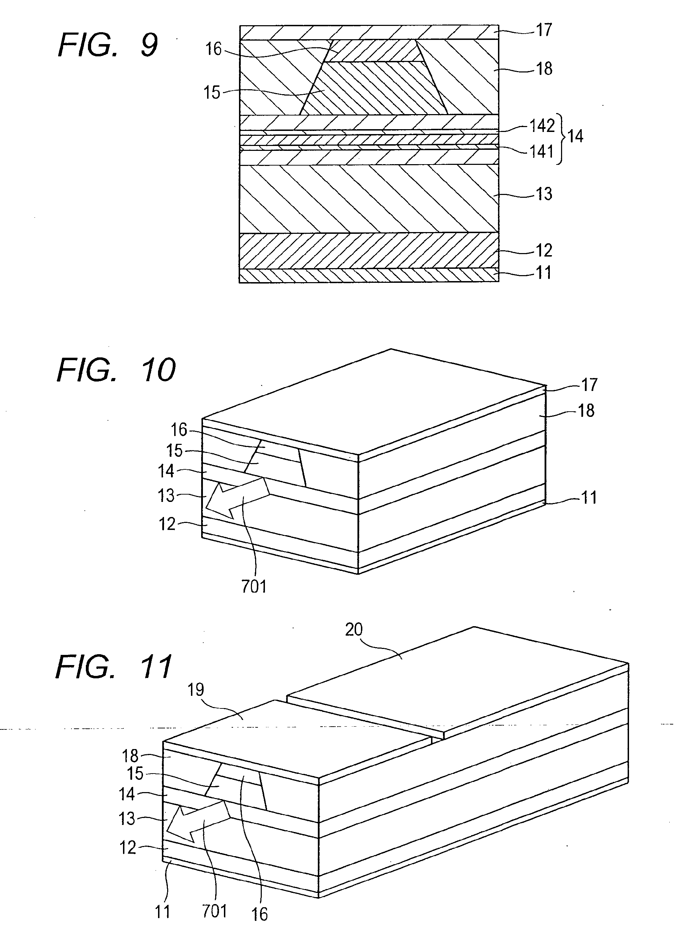

A superluminescent diode (SLD) of Example 1 of the present invention is described with reference to FIG. 9.

With reference to FIG. 9, an n-clad layer (n-side optical confinement layer) 13 formed of n-type $Al_{0.55}Ga_{0.45}As$, a multiple quantum well active layer (MQW active layer) 14, and a p-clad layer (p-side optical confinement layer) 15 formed of p-type $Al_{0.55}Ga_{0.45}As$ are formed on an n-type GaAs substrate 12, and further, a p-type electrode 17 is formed thereon via a contact layer 16 formed of GaAs. An n-type electrode 11 is formed on a rear surface of the n-type GaAs substrate 12. The MQW active layer 14 includes a first quantum well 141 as a first quantum well structure and a second quantum well 142 as a second quantum well structure. The first quantum well 141 is formed of InGaAs and has a well width of 8 nm, and the second quantum well 142 is formed of InGaAs and has a width of 7 nm. A barrier layer is formed of $Al_{0.25}Ga_{0.75}As$ and has a well width of 10 nm. A quantum level is independently formed in each of the two quantum wells, which are in an uncoupled state.

FIG. 10 is a perspective view of the SLD illustrated in FIG. 9. By slanting a ridge stripe with respect to an end surface by an angle of up to 7°, reflection is reduced to the minimum. An insulating protective layer 18 is formed on the end surface.

FIG. 11 is a perspective view of an SLD including a plurality of current injection regions, in this case, two p-type electrodes, i.e., a front electrode portion 19 and a rear electrode portion 20. By superimposing, on a spectrum in which light emitted from heavy holes having a primary energy level, which is obtained by current injection into the front electrode portion 19 serving as a current injection region on a light exit end side, is dominant, a spectrum in which light emitted from a ground state energy level generated in the rear electrode portion 20 is dominant and is guided and amplified, a large output light emission 701 having a wide-band spectrum is obtained. In this case, in the front electrode portion 19 serving as the current injection region on the light exit end side, current injection at a level at which light emission from the primary energy level is dominant is performed. In the rear electrode portion 20 serving as another current injection region, current injection at a level at which light emission from the ground state energy level is dominant is performed. It is preferred that the front electrode portion 19 serving as the current injection region on the light exit end side be shorter than the rear electrode portion 20 serving as the another current injection region and current be injected in the front electrode portion 19 at a higher current density than in the rear electrode portion 20.

To lengthen the rear electrode portion 20 is effective in maintaining the spectrum in which light emitted from the ground state energy level is dominant.

The first quantum well 141 has a larger well width and a smaller well layer In content than those of the second quantum well 142.

FIG. 2 is change in optical output in a structure in which the first quantum well has a well width of 8 nm and a well layer composition of $In_{0.1}Ga_{0.9}As$ when the well width (3.5 nm to 7 nm) and a well layer In content x of the second quantum well ($In_xGa_{1-x}As$) are changed.

With reference to FIG. 2, a well layer In content of the second quantum well with which the optical output is increased exists with regard to each of the well widths of the second quantum well. FIG. 2 is also, for reference, an optical output of a symmetric quantum well active layer in which two first quantum wells are laminated (having a well width of 8 nm and a well layer of $In_{0.1}Ga_{0.9}As$). When the second quantum well has a well width that is 1/2 or more of that of the first quantum well and is 4.5 nm or more, a well layer In content of the second quantum well exists with which, although the total well width of the asymmetric quantum well active layer is smaller, the optical output thereof" becomes larger than that of the symmetric quantum well active layer.

FIG. 6A is a graph in which the difference $\Delta In_x$ determined by subtracting the In content $In_x(Lw)$ of the first quantum well from the maximum In content $In_x$-$max(Ln)$ and from the minimum In content $In_x$-$min(Ln)$ with regard to various well widths of the second quantum well is plotted as a function of the well width Ln of the second quantum well serving as the smaller well width in the asymmetric double quantum well active layer shown in FIG. 2 and having a larger optical output than that of the symmetric double quantum well active layer having a well width of 8 nm.

When the well width Ln of the second quantum well is smaller than the well width Lw of the first quantum well by 0.1 nm or more and is 1/2 or more of the well width Lw of the first quantum well and 4.5 nm or more, and when the difference $\Delta In_x$ between the In content of the second quantum well and the In content of the first quantum well is between the fitted curve of the maximum In content difference $\{In_x$-$max(Ln)\}$-$In_x(Lw)$ and the fitted curve of the minimum In content difference $\{In_x$-$min(Ln)\}$-$In_x(Lw)$, the optical output of the asymmetric double quantum well active layer is larger than that of the symmetric quantum well active layer in which two first quantum wells are laminated.

With regard to an arbitrary value of Ln/Lw, by locating the In content difference $\Delta In_x$ between the maximum fitted curve and the minimum fitted curve, that is, by allowing the In content difference $\Delta In_x$ to satisfy Expression (1) that expresses the fitted curves in mathematical form, an optical output that is larger than that of the symmetric double quantum well active layer in which two first quantum wells having the well width Lw are stacked can be obtained.

$$0.0631(Ln/Lw)^2-0.134(Ln/Lw)+0.0712<In_x(Ln)-In_x(Lw)$$

$$<0.0068(Ln/Lw)^2-0.1995(Ln/Lw)+0.192 \qquad (1)$$

It is to be noted that in this example, a structure is described in which the first quantum well having the larger well width is arranged on the p-doped side in the active layer, but similar characteristics can be obtained when the first quantum well is arranged on the n-doped side.

Table 1 is optical outputs of structures in which the places of the first quantum well of $In_{0.1}GaAs$ having a well width of 8 nm and the second quantum well of $In_{0.11}GaAs$ having a well width of 7 nm are changed. Regardless of the places of the first quantum well and the second quantum well, the optical output is increased.

As comparative examples, optical outputs of structures in which two quantum wells having a well width of 8 nm are laminated are also shown. In these structures, when one well layer In content is changed by 0.001, the optical output is reduced to about a half thereof, and thus, an allowable range of fluctuations in In content when the well layer is formed is very narrow.

On the other hand, in the structure of this example, an allowable range of the well layer In content is wide, and an SLD light emitting element having a large optical output can be obtained with a high yield.

Table 1

| Optical output change due to double quantum well arrangement | | |
|---|---|---|
| Active layer structure Well composition/width | Optical output (arb.) | |
| $In_{0.1}GaAs(8)/In_{0.11}GaAs$ (7) | 2.0 | Example 1 |
| $In_{0.11}GaAs(7)/In_{0.1}GaAs$ (8) | 2.35 | Example 1 |
| | | |
| $In_{0.1}GaAs(8)/In_{0.99}GaAs$ (8) | 0.63 | Comparative Example |
| $In_{0.1}GaAs(8)/In_{0.1}GaAs(8)$ | 1.25 | Comparative Example |
| $In_{0.1}GaAs(8)/In_{0.101}GaAs$ (8) | 0.75 | Comparative Example |

[Example 2]

A superluminescent diode (SLD) of Example 2 of the present invention is described also with reference to FIG. 9.

With reference to FIG. 9, this example is different from Example 1 in that the MQW active region 14 includes a well layer having the first quantum well structure of $Al_{0.1}GaAs$ having a well width of 8 nm and a well layer having the second quantum well structure of $Al_{0.093}GaAs$ having a well width of 7 nm.

The first quantum well has a larger well width and a larger well layer Al content than those of the second quantum well.

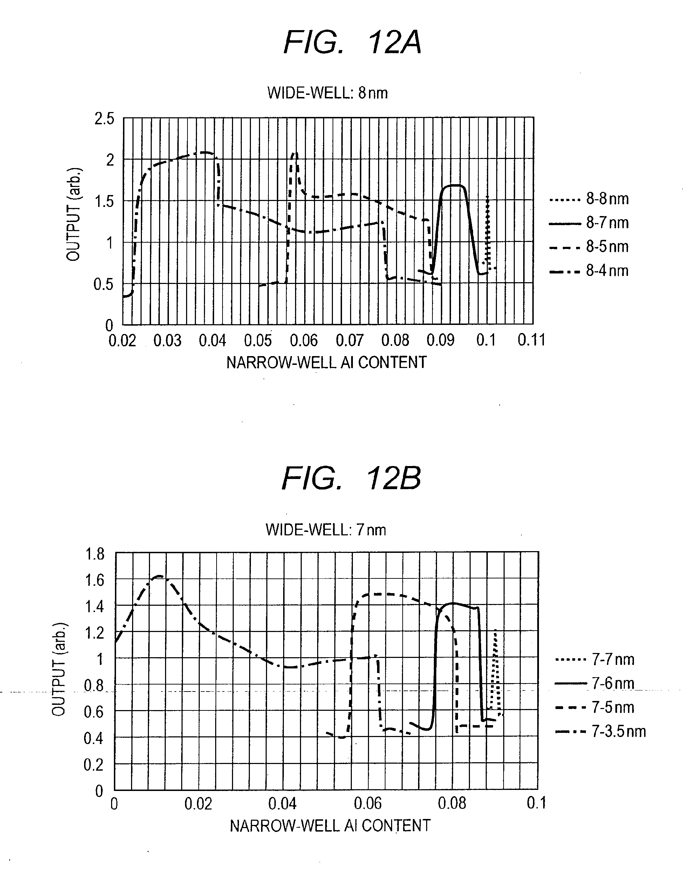

FIG. 12A is change in optical output in a structure in which the first quantum well has a well width of 8 nm and a well layer composition of $Al_{0.1}Ga_{0.9}As$, and the second quantum well has well widths of 7.5 nm, 7 nm, 6 nm, 5 nm, and 4 nm and a well layer Al content that is changed.

With regard to each of the well widths of the second quantum well, an Al content with which the optical output is increased to about twice or more exists, and, as the well width of the second quantum well becomes smaller, the range of the Al content in which the optical output is increased becomes wider. When the second quantum well has a well width of 7 nm and the Al content is 0.09 to 0.095, when the second quantum well has a well width of 6 nm and the Al content is 0.078 to 0.093, which is a wider range, and, when the second quantum well has a well width of 5 nm and the Al content is 0.078 to 0.093, which is a still wider range, increase in optical output is obtained.

In FIG. 12A, for reference, an optical output of a symmetric quantum well active layer in which two quantum wells having a well width of 8 nm are laminated is also shown. With regard to the symmetric quantum well, when difference in Al content between the two well layers is about 0.001, the optical output considerably reduces to 1/2.5.

In this structure, the optical output is increased in a wide range of the Al content of the second quantum well layer, and thus, an allowable range in manufacture is wide, and the structure is very effective.

FIG. 12B is change in optical output in a structure in which the first quantum well has a well width of 7 nm and a well layer composition of $Al_{0.09}Ga_{0.91}AS$, and the second quantum well has well widths of 6 nm, 5 nm, and 4 nm and a well layer Al content that is changed.

Similarly to FIG. 12A, there is a region in which the optical output increases depending on the well width of the second quantum well.

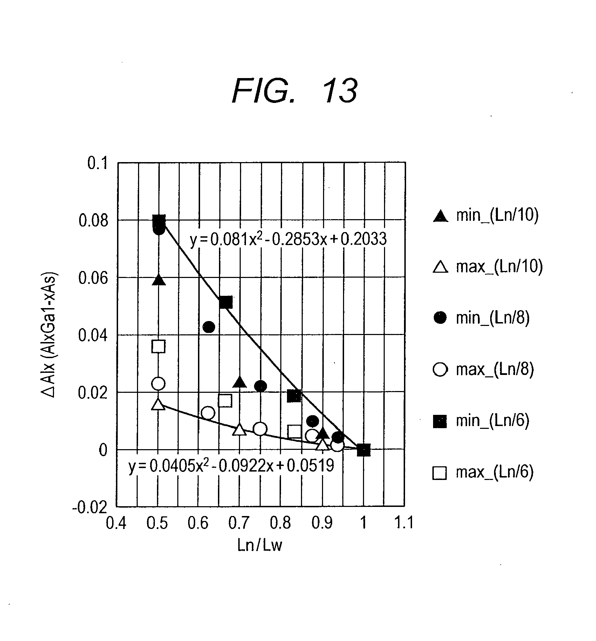

With reference to FIG. 13, with regard to a result of study when the first quantum well has a well width of 6 nm or more and 10 nm or less, the horizontal axis denotes the ratio Ln/Lw of the second quantum well width Ln to the first quantum well width Lw. The vertical axis denotes $Al_x(Lw)-Al_x\text{-}max(Ln)$ as the difference between the maximum Al content $Al_x\text{-}max(Ln)$ of the second quantum well with which the optical output is increased and the well layer Al content of the first quantum well, and $Al_x(Lw)-Al_x\text{-}min(Ln)$ as the difference between the minimum Al content $Al_x\text{-}min(Ln)$ of the second quantum well with which the optical output is increased and the well layer Al content of the first quantum well.

With reference to FIG. 13, when the value Ln/Lw is the same, as Lw becomes smaller, the Al content difference $Al_x(Lw)-Al_x\text{-}max(Ln)$ becomes larger, and a maximum fitted curve of the maximum Al cantent difference passing by the maximum values is obtained.

On the other hand, when the value Ln/Lw is the same, as Lw becomes larger, the minimum Al content difference $Al_x(Lw)-Al_x\text{-}min(Ln)$ becomes smaller.

In a region between the two fitted curves in FIG. 13, the optical output is increased, and this is expressed by the following conditional expression in which the two fitted curves are expressed in mathematical form.

$$0.0405(Ln/Lw)^2-0.0922(Ln/Lw)+0.0519<Al_x(Lw)-Al_x(Ln)$$

$$<0.081(Ln/Lw)^2-0.2853(Ln/Lw)+0.2033 \qquad (2)$$

When the larger well width Lw, the well layer Al content $Al_x(Lw)$, the smaller well width Ln, and the well layer Al content $Al_x(Ln)$ of the asymmetric quantum well active layer satisfy Conditional Expression (2), even if the well layer Al content fluctuates in manufacturing, a light emitting device having a large and stable optical output is obtained.

[Example 3]

A light source of an optical coherence tomography apparatus is required to have an emission profile having a wide bandwidth of about 100 nm. In realizing such a wide emission profile by superimposition of a plurality of emission peaks having different emission peak wavelengths, the intensities of the respective emission peaks are required to be similar. Example 3 is a structure that realizes a ratio of approximately three or less of a maximum to a minimum of main emission peaks from an asymmetric double quantum well active layer.

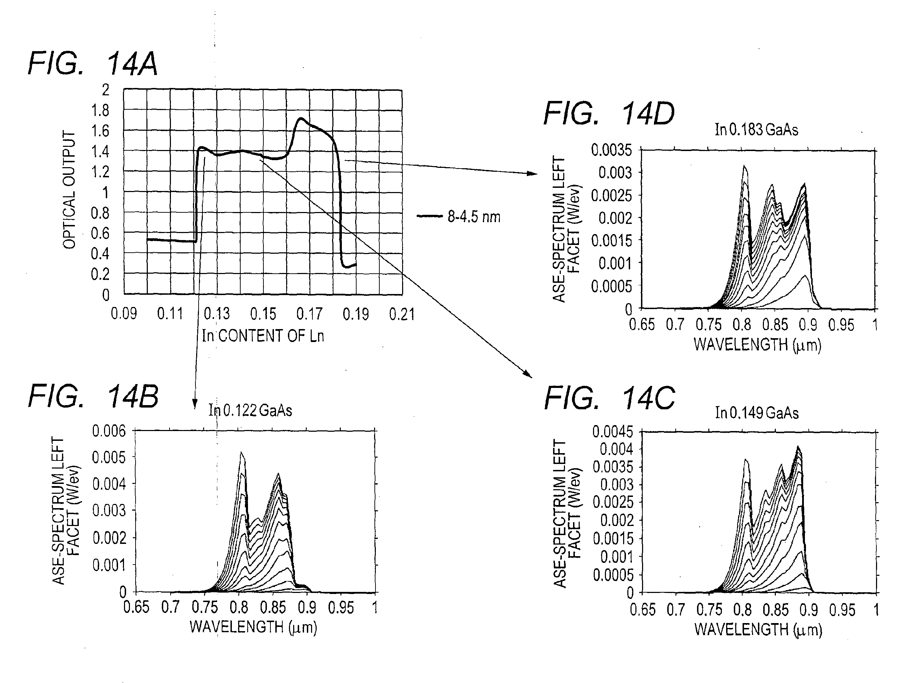

In FIG. 14A, the first quantum well of $In_{0.1}Ga_{0.9}As$ having a well width of 8 nm and the second quantum well of $In_xGa_{1-x}As$ having a well width of 4.5 nm of Example 1 illustrated in FIG. 2 are extracted and shown. Emission profiles of the second quantum well having a well width of 4.5 nm when the In content takes on three different values are shown (FIGS. 14B, 14C, and 14D). FIG. 14B is an asymmetric double quantum well active layer including a first quantum well of $In_{0.1}GaAs$ having a well width of 8 nm and a second quantum well of $In_{0.122}GaAs$ having a well width of 4.5 nm. There are two main emission peaks, and the emission profile is narrow. On the other hand, FIGS. 14C and 14D show emission profiles of an active layer including a first quantum well of $In_{0.1}GaAs$ having a well width of 8 nm and a second quantum well of $In_{0.149}GaAs$ having a well width of 4.5 nm, and an active layer including a first quantum well of $In_{0.1}GaAs$ having a well width of 8 nm and a second quantum well of $In_{0.183}GaA3$ having a well width of 4.5 nm, respectively. There are three to four main emission peaks, and the emission profiles are as wide as 100 nm or more with intensity ratios of two or less.

The emission peak depends on heavy holes and light holes at the ground state energy level and heavy holes at the primary energy level in the first quantum well, and heavy holes and light holes at the ground state energy level in the second quantum well, and a part of the emission peaks in the emission profiles overlap to hinder discrimination thereof.

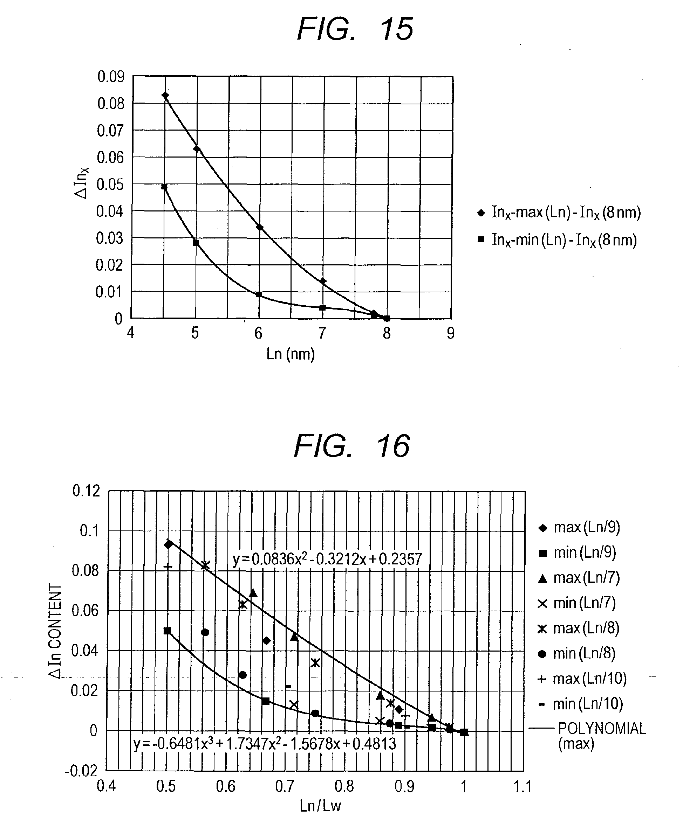

FIG. 15 is a graph for showing a range of the well width Ln and the In content $In_x(Ln)$ of the second quantum well in which the ratio of the maximum to the minimum of a plurality of emission peak intensities when the first quantum well of $In_{0.1}GaAs$ has a well width of 8 nm is approximately three or less. The vertical axis denotes the In content difference $\Delta In_x$ ($In_x$-max(Ln)-$In_x$(Lw)) and ($In_x$-min(Ln)-$In_x$(Lw)) determined by subtracting the In content $In_x$(Lw) of the first quantum well from the maximum In content $In_x$-max(Ln) and from the minimum In content $In_x$-min(Ln), respectively, of the second quantum well when the ratio of the maximum to the minimum of the plurality of emission peak intensities is approximately three or less, and the In content difference $\Delta In_x$ is plotted as a function of the well width Ln of the second quantum well.

An asymmetric double quantum well active layer having a structure between a fitted curve passing by the maximum values of the In content difference $\Delta In_x$ ($In_x$-max(Ln)-$In_x$(Lw)) and a fitted curve passing by the minimum values of the In content difference $\Delta In_x$ ($In_x$-min(Ln)-$In_x$(Lw)) with regard to the respective values of the well width Ln of the second quantum well is to be an SLD having a wide emission profile and having characteristics in which the ratio of the maximum to the minimum of the plurality of emission peak intensities is approximately three or less.

FIG. 16 is a graph for showing the well width Ln and the In content $In_x(Ln)$ of the second quantum well when the emission profile has a ratio of the maximum to the minimum of a plurality of emission peak intensities of approximately three or less with regard to different values of the well width Lw and the In content $In_x$(Lw) of the first quantum well.

For the purpose of comparing together dependence on the well width of different first quantum wells, the horizontal axis denotes the ratio Ln/Lw of the second quantum well width to the first quantum well width. The vertical axis denotes, similarly to the case of FIG. 15, the In content difference $\Delta In_x$ determined by subtracting the In content $In_x$(Lw) of the first quantum well from the maximum value $In_x$-max (Ln) and from the minimum value $In_x$-min(Ln), respectively, of the In content $In_x(Ln)$ with regard to the well width Ln of the second quantum well.

In FIG. 15, a fitted curve of the maximum In content difference $\Delta In_x$ and a fitted curve of the minimum In content difference $\Delta In_x$ are depicted. The fitted curve connecting the minimum values of In content difference $\Delta In_x$ forms a fitted curve of data points with the first quantum well width Lw of Lw=9 nm.

With regard to an arbitrary value of Ln/Lw, an asymmetric double quantum well active layer having a structure between a fitted curve of the maximum values and a fitted curve of the minimum values of the In content difference $\Delta In_x$ is to be an SLD having emission profile characteristics in which the ratio of the maximum to the minimum of the plurality of emission peak intensities is approximately three or less. Specifically, satisfaction by Lw and $In_x$(Lw) of the first quantum well and Ln and $In_x(Ln)$ of the second quantum well of Expression (3) that is a condition for existing between expressions representing the two fitted curves in FIG. 16 is a condition for obtaining an SLD having a large optical output and having wide emission profile characteristics.

Specifically, the following semiconductor light emitting element is provided.

In other words, the well width Lw and the well layer In content $In_x$(Lw) of the first quantum well and the well width Ln and the well layer In content $In_x(Ln)$ of the second quantum well satisfy the following conditions:

Lw is 7 nm or more and 10 nm or less; and
Ln is smaller than Lw by 0.1 nm or more, is 1/2 or more of Lw, and is 4.5 nm or more.

Further, Expression (3) is satisfied.

$$-0.6481(Ln/Lw)^3+1.7347(Ln/Lw)^2-1.5678(Ln/Lw)+0.4813$$

$$<In_x(Ln)-In_x(Lw)<0.0.0836(Ln/Lw)^2-0.3212(Ln/Lw)+0.2357 \quad (3)$$

It is to be noted that in this example, a structure is described in which the first quantum well having the larger well width is arranged on the p-doped side in the active layer, but similar characteristics can be obtained when the first quantum well is arranged on the n-doped side.

[Example 4]

Example 4 is a structure that realizes further increase in optical output by additionally forming a third quantum well on the n-doped side of the asymmetric double quantum well active layer.

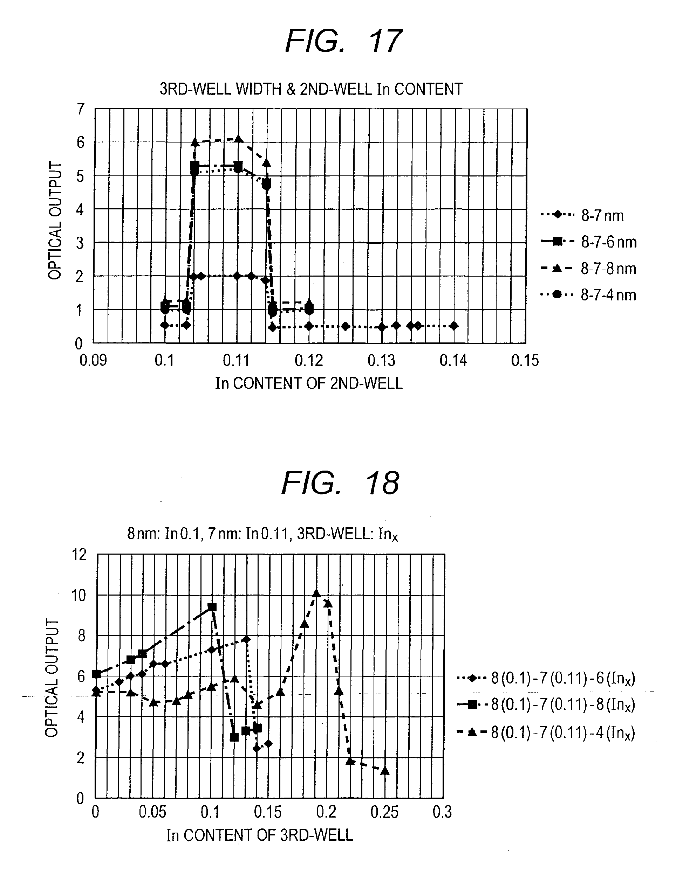

FIG. 17 is a graph for showing dependence on the In content of the second quantum well of optical output characteristics of an SLD having a triple quantum well (3QW) active layers in which a third quantum well is added on the n-doped side of the asymmetric double quantum well.

The triple quantum well active layer includes a first quantum well of $In_{0.1}GaAs$ having a well width of 8 nm, a second quantum well of $In_xGa_{1-x}As$ having a well width of 7 nm, and a third quantum well of GaAs having a well width of 4 nm, 6 nm, or 8 nm.

For reference, optical output characteristics of the asymmetric double quantum well structure of Example 1 including a first quantum well of $In_{0.1}GaAs$ having a well width of 8 nm and a second quantum well of $In_xGa_{1-x}As$ having a well width of 7 nm are also shown.

By additionally forming the third quantum well, the optical output that is increased depending on the In content of the second quantum well in the asymmetric double quantum well structure is further increased to 2.5 to 3 times.

FIG. 18 is dependence on the In content of the third quantum well of the optical output of the 3QW active layer of an SLD. In a structure including a first quantum well of $In_{0.1}GaAs$ having a well width of 8 nm and a second quantum well of $In_{0.11}GaAs$ having a well width of 7 nm, if the In content of the third quantum well of $In_xGa_{1-x}As$ is 0 to 0.21 when the well width is 4 nm, 0 to 0.13 when the well width is 6 nm, and 0 to 0.1 when the well width is 8 nm, the optical output is increased.

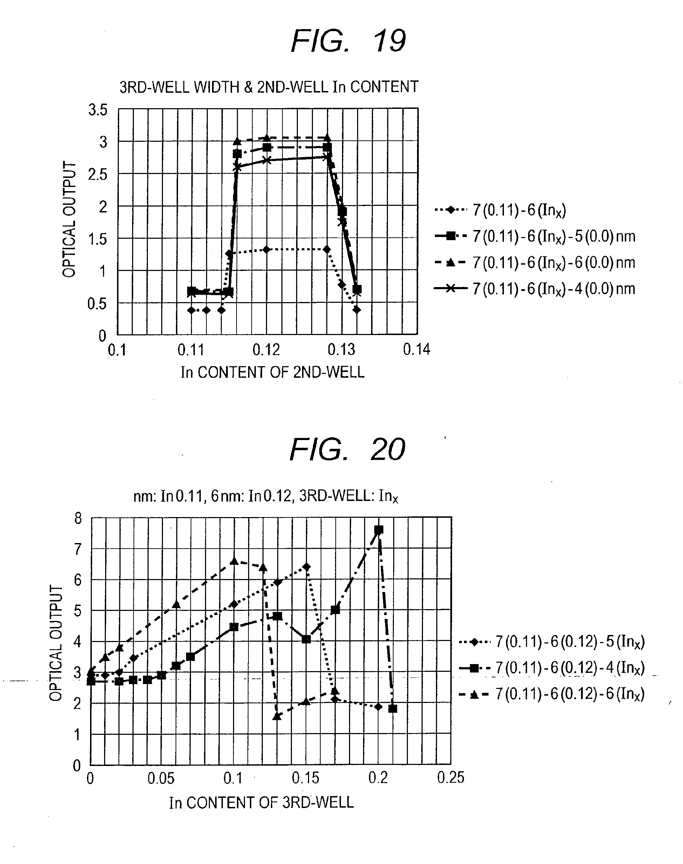

FIG. 19 is dependence on the In content of the second quantum well of the 3QW active layers including different quantum wells, and dependence on the In content of the second quantum well of optical output characteristics of an SLD including a first quantum well of $In_{0.11}GaAs$ having a well width of 7 nm, a second quantum well of $In_xGa_{1-x}As$ having a well width of 6 nm, and a third quantum well of GaAs having a well width of 4 nm, 5 nm, or 6 nm. Similarly to the case of FIG. 17, by additionally forming the third quantum well, an optical output that is considerably increased compared with an asymmetric double quantum well structure is obtained.

FIG. 20 is dependence on the In content of the third quantum well of $In_xGa_{1-x}As$, when the first quantum well of $In_{0.1}GaAs$ has a well width of 8 nm and the second quantum well of $In_{0.11}GaAs$ has a well width of 7 nm. In a structure including a first quantum well of $In_{0.11}GaAs$ having a well width of 7 nm and a second quantum well of $In_{0.12}GaAs$ having a well width of 6 nm, if the In content of the third quantum well of $In_xGa_{1-x}As$ is 0 to 0.2 when the well width is 4 nm, 0 to 0.15 when the well width is 5 nm, and 0 to 0.12 when the well width is 6 nm, the optical output is increased.

Such increase in optical output by additionally forming the third quantum well is obtained in the structure of Example 1 in which the optical output of the asymmetric double quantum well active layer is increased. Conditions of the third quantum well under which the optical output is increased by additionally forming the third quantum well are that the well width of the third quantum well is equal to or smaller than and 1/2 or more of the well width of the first quantum well, and that the In content of the well layer of $In_xGa_{1-x}As$ is 0.21 or less.

Specifically, the following semiconductor light emitting element is provided, which has a multiple quantum well active layer including the first quantum well, the second quantum well, and the third quantum well on the n-doped side, which have different well widths.

The first quantum well has a larger well width than that of the second quantum well and is formed of a material having a wider well layer band gap.

The well layers of the first quantum well and the second quantum well are formed of $In_xGa_{1-x}As$, and the well width Lw and the well layer In content $In_x(Lw)$ of the first quantum well, the well width Ln and the well layer In content $In_x(Ln)$ of the second quantum well, and a well width L3 and a well layer In content $In_x(L3)$ of the third quantum well satisfy the following conditions:

Lw is 6 nm or more and 10 nm or less;
Ln is smaller than Lw by 0.1 nm or more, and is 1/2 or more of Lw; and
L3 is equal to or smaller than Lw and is 1/2 or more of Lw, and the well layer In content $In_x(L3)$ is 0 or more and 0.21 or less.

Further, Lw, Ln, $In_x(Lw)$, and $In_x(Ln)$ satisfy Expression (1).

$$0.0631(Ln/Lw)^2 - 0.134(Ln/Lw) + 0.0712 < In_x(Ln) - In_x(Lw)$$

$$< 0.0068(Ln/Lw)^2 - 0.1995(Ln/Lw) + 0.192 \quad (1)$$

It is to be noted that in this example, a structure is described in which the third quantum well is arranged on the n-doped side in the active layer with respect to the first quantum well and the second quantum well, but similar characteristics can be obtained when the third quantum well is arranged on the p-doped side, or when the third quantum well is arranged between the first quantum well and the second quantum well.

Table 2 is optical outputs of structures in which the places of the first quantum well of $In_{0.1}GaAs$ having a well width of 8 nm, the second quantum well of $In_{0.11}GaAs$ having a well width of 7 nm, and the third quantum well of GaAs having a well width of 6 nm are changed. Regardless of the place of the third quantum well, the optical output is increased, but, -by arranging the third quantum well of GaAs having a well width of 6 nm on the n-doped side or on the p-doped side, a still larger optical output can be obtained.

As a comparative example, an optical output of a structure including the first and second quantum wells both of $In_{0.1}GaAs$ and having a well width of 8 nm and the third quantum well of GaAs having a well width of 6 nm is also shown.

Table 2

| Optical output change due to position of third quantum well | | |
|---|---|---|
| Active layer structure (3QW) Well composition/width | Optical output (arb.) | |
| $In_{0.1}GaAs$ (8)/$In_{0.11}GaAs$(7)/GaAs(6) | 5.3 | Example 4 |
| $In_{0.1}GaAs$ (8)/GaAs(6)/$In_{0.11}GaAs$ (7) | 3.6 | Example 4 |
| GaAs (6)/$In_{0.1}GaAs$ (8)/$In_{0.11}GaAs$ (7) | 4.1 | Example 4 |
| GaAs (6)/$In_{0.11}GaAs$ (7) / $In_{0.1}GaAs$ (8) | 5.4 | Example 4 |
| $In_{0.11}GaAs$ (7) /GaAs (6) /$In_{0.1}GaAs$ (8) | 4.8 | Example 4 |
| $In_{0.11}GaAs$ (7) /$In_{0.1}GaAs$ (8) /GaAs (6) | 5.3 | Example 4 |
| | | |
| $In_{0.1}GaAs$ (8) /$In_{0.1}GaAs$ (8) /GaAs (6) | 1.8 | Comparative Example |

[Example 5]

Example 5 is an example that realizes an increased optical output while maintaining a wide-band emission profile by additionally forming a third quantum well on the n-doped side of the asymmetric double quantum well active layer.

While the asymmetric double quantum well active layer of Example 3 obtains emission profile characteristics in which the ratio of the maximum to the minimum of the main emission peaks is approximately three or less, by additionally forming the third quantum well, while the wide-band profile is maintained, the optical output can be increased and a dip in the emission profile can be reduced.

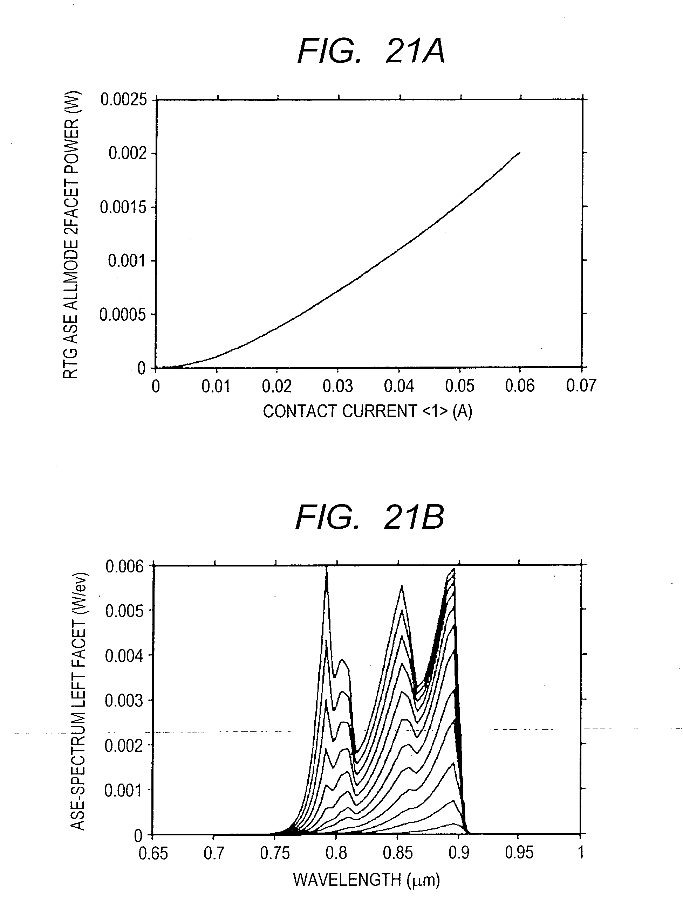

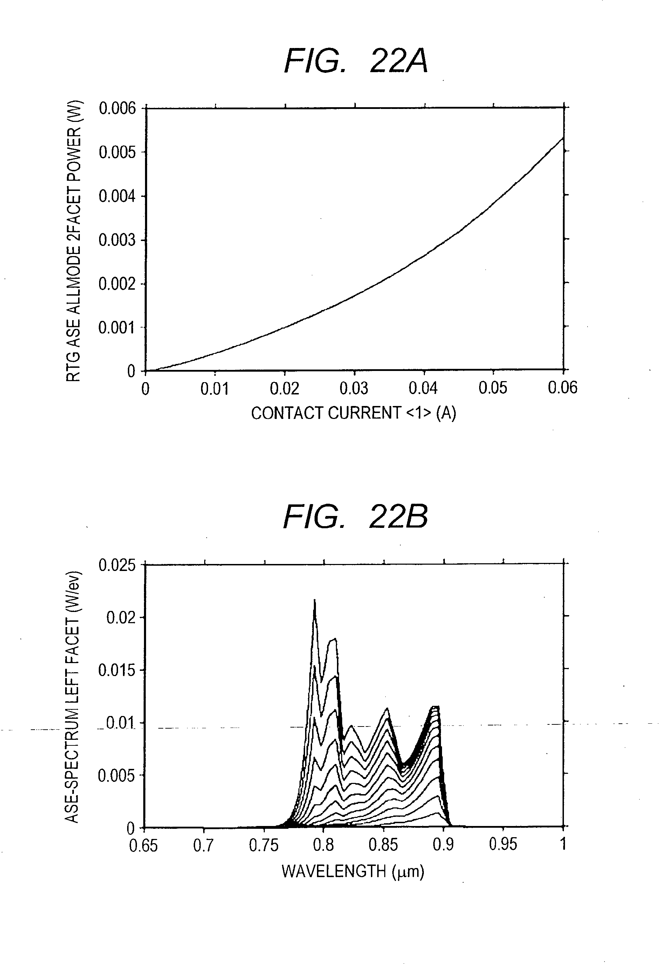

FIGS. 21A and 21B show optical output characteristics and an emission profile, respectively, of an SLD including the first quantum well of $In_{0.1}GaAs$ having a well width of 8 nm and the second quantum well of $In_{0.11}GaAs$ having a well width of 7 nm as a structure of the asymmetric double quantum well active layer of Example 3. FIGS. 22A and 22B show optical output characteristics and an emission profile, respectively, of a 3QW active layer of an SLD in which the third quantum well of GaAs having a well width of 6 nm is additionally formed on the n-doped side. Compared with the case shown in FIG. 21A, the optical output is increased to be about three times as much, and a dip on a shortwave side of the emission profile in FIG. 21B is reduced in the obtained emission profile. The ratio of the maximum to the minimum of the main emission peaks is held at three or less. It is to be noted that increase in intensity of two emission peaks on the shortwave side can be controlled by adjusting injected current.

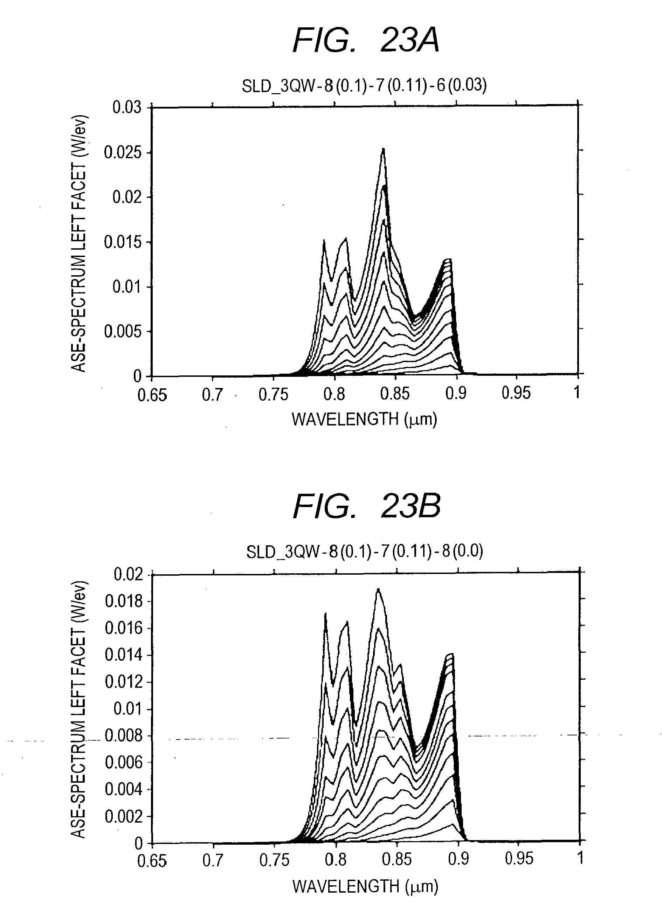

Further, if the third quantum well is formed of $In_{0.03}GaAs$ and has a well width of 6 nm, as shown in FIG. 23A, compared with a 2QW structure, a profile can be obtained in which the optical output is held at about three times as much and the intensity of a wavelength around a center thereof is increased.

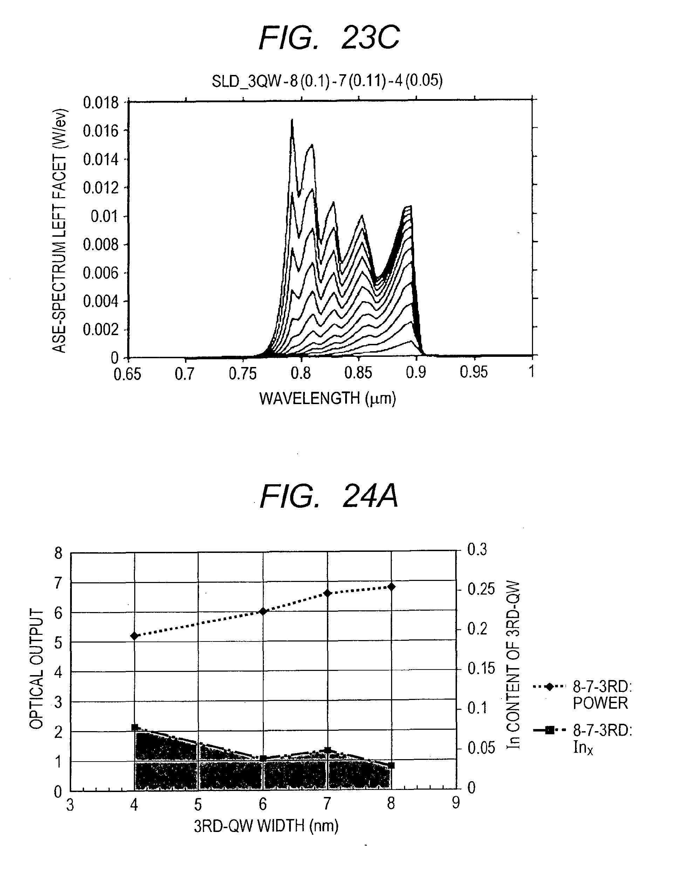

FIGS. 23B and 23C show emission profiles of a structure in which the third quantum well is formed of GaAs and has a well width of 8 nm, and a structure in which the third quantum well is formed of $In_{0.04}GaAs$ and has a well width of 5 nm, respectively. With regard to both of the profiles, while the ratio of the maximum to the minimum of the main emission peaks is held at approximately three or less, the optical output is increased and a dip in the emission profile is reduced.

FIG. 24A is an In content region (shaded portion below the dashed line in FIG. 24A) of a well layer of $In_xGa_{1-x}As$ of the third quantum well that holds the ratio of the maximum to the minimum of the main emission peaks at approximately three or less, and still, increases the optical output and obtains a wide-band profile with a reduced dip when the first quantum well is formed of $In_{0.1}GaAs$ and has a well width of 8 nm, the second quantum well is formed of $In_{0.11}GaAs$

and has a well width of 7 nm, and the third quantum well has a well width of 4 nm, 6 nm, 7 nm, or 8 nm.

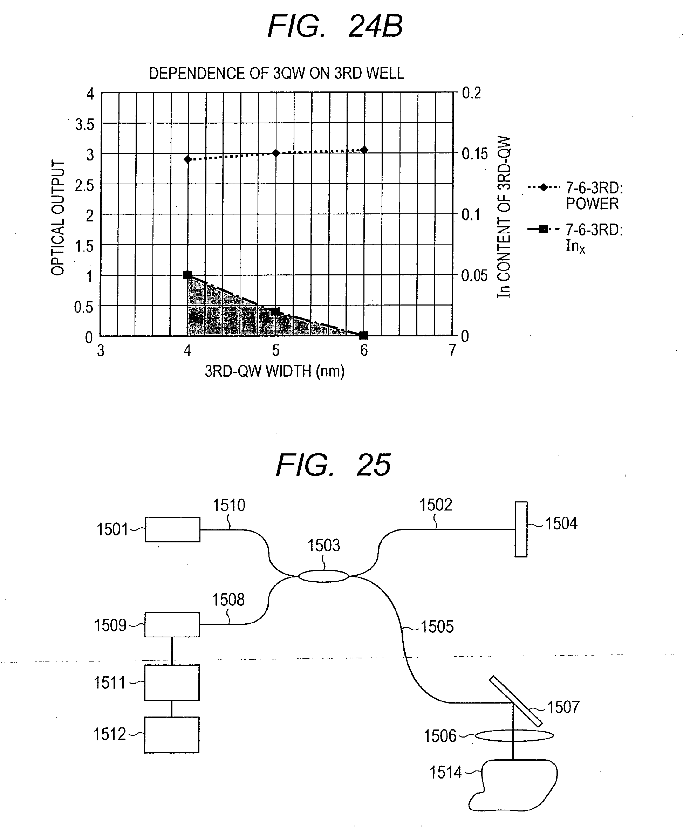

FIG. 24B is a graph showing the characteristics of a different 3QW structure, and is an In content region (shaded portion below the dashed line in FIG. 24B) of a well layer of $In_xGa_{1-x}As$ of the third quantum well that holds the ratio of the maximum to the minimum of the main emission peaks at approximately three or less, and still, increases the optical output and obtains a wide-band profile with a reduced dip when the first quantum well is formed of $In_{0.11}GaAs$ and has a well width of 7 nm, the second quantum well is formed of $In_{0.12}GaAs$ and has a well width of 6 nm, and the third quantum well has a well width of 4 nm, 5 nm, or 6 nm.

Such increase in optical output and reduction of a dip in the emission profile by a 3QW active layer while holding the ratio of the maximum to the minimum of the main emission peaks at appropriately three or less is possible with regard to other combinations of the quantum wells. Specifically, these effects can be obtained by additionally forming a quantum well, which has a well width that is equal to or smaller than the first quantum well width, is 1/2 or more of the first quantum well width, and is 4 nm or more, and has a well layer of $In_xGa_{1-x}As$ and an In content of 0.08 or less, on the p-doped side of the asymmetric double quantum well active layer that satisfies the conditions of Example 3.

Specifically, the following semiconductor light emitting element is provided.

The well width Lw and the well layer In content $In_x(Lw)$ of the first quantum well, the well width Ln and the well layer In content $In_x(Ln)$ of the second quantum well, and the well width L3 and the well layer In content $In_x(L3)$ of the third quantum well satisfy the following conditions:

Lw is 7 nm or more and 10 nm or less; and
Ln is smaller than Lw by 0.1 nm or more, is 1/2 or more of Lw, and is 4.5 nm or more.

Further, Expression (3) is satisfied.

$$-0.6481(Ln/Lw)^3+1.7347(Ln/Lw)^2-1.5678(Ln/Lw)+0.4813$$

$$<In_x(Ln)-In_x(Lw)<0.0836(Ln/Lw)^2-0.3212(Ln/Lw)+0.2357 \qquad (3)$$

Further, L3 is Lw or less, 1/2 or more of Lw, and is 4 nm or more, and $In_x(L3)$ is 0 or more and 0.08 or less.

It is to be noted that in this example, a structure is described in which the third quantum well is arranged on the n-doped side in the active layer with respect to the first quantum well and the second quantum well, but similar characteristics can be obtained when the third quantum well is arranged on the p-doped side, or when the third quantum well is arranged between the first quantum well and the second quantum well.

Table 2 is optical outputs of structures in which the places of the first quantum well of $In_{0.1}GaAs$ having a well width of 8 nm, the second quantum well of $In_{0.11}GaAs$ having a well width of 7 nm, and the third quantum well of GaAs having a well width of 6 nm are changed. Regardless of the places of the first quantum well, the second quantum well, and the third quantum well, the optical output is increased.

As a comparative example, an optical output of a structure including the first and second quantum wells both of $In_{0.1}GaAs$ and having a well width of 8 nm and the third quantum well of GaAs having a well width of 6 nm is also shown. In the structure of the comparative example, the optical output is reduced to a half or less.

[Example 6]

In this example, an optical coherence tomography apparatus in which the semiconductor light emitting element according to the present invention is used in a light source portion is described.

FIG. 25 is a schematic view of the optical coherence tomography apparatus of this example.

The optical coherence tomography apparatus illustrated in FIG. 25 basically includes a light source portion (1501 and the like), an object measuring portion (1507 and the like) for radiating light from the light source portion to an object and for transmitting reflected light from the object, a reference portion (1502 and the like) for radiating light from the light source portion to a reference mirror and for transmitting reflected light from the reference mirror, a coherence portion (1503) for achieving coherence between reflected light from the object measuring portion and reflected light from the reference portion, an optical detection portion (1509 and the like) for detecting coherent light obtained by the coherence portion, and an image processing portion (1511) for performing image processing based on light detected by the optical detection portion to acquire a tomography image of the object. These components are described in the following.

In the light source portion, an SLD light source 1501 is connected via an optical fiber 1510 for light radiation to a fiber coupler 1503 forming the coherence portion.

The fiber coupler 1503 of the coherence portion is in a single mode in a wavelength band of the light source, and the fiber coupler of various kinds is a 3dB coupler.

A reflecting mirror 1504 is connected to a fiber 1502 for a reference light optical path to form the reference portion. The fiber 1502 for a reference light optical path is connected to the fiber coupler 1503.

A fiber 1505 for an inspection light optical path, a radiation light condensing optical system 1506, and a mirror 1507 for radiation location scanning form the object measuring portion. The fiber 1505 for an inspection light optical path is connected to the fiber coupler 1503. In the fiber coupler 1503, back scattering light from an inside and a surface of an object (an object to be inspected) 1514 and return light from the reference portion interfere with each other to be coherent light.

The optical detection portion includes a fiber 1508 for receiving light and an optical detection portion 1509 that includes a spectroscopic unit and an array-type optical detection unit, and spectroscopically detects coherent light having a wide-band emission spectrum with regard to each wavelength band.

Light received by the array-type optical detection unit of the optical detection portion 1509 is converted into a spectrum signal by a signal processor 1511. By further performing a Fourier transform on the converted spectrum signal, information in a depth direction of the object is acquired. The acquired information in the depth direction is displayed as a tomography image on an image output monitor 1512.

In this case, the signal processor 1511 may be a personal computer or the like, and the image output monitor 1512 may be a display screen of the personal computer or the like.

For example, when the SLD light source device described in Examples 1 to 5 is used as the SLD light source (wavelength tunable light source) 1501 of this example, the SLD light source device has a wide-band emission spectrum, and thus, tomography image information with high resolution of information in the depth direction can be acquired. The optical coherence tomography apparatus is useful for tomography imaging in ophthalmology, dentistry, dermatology, and the like.

The semiconductor light emitting element having the asymmetric quantum well active layer described above has high emission efficiency and can increase the optical output, and thus, can be used as a light source for display, a light source for optical communications, and a light source for optical measurement. Further, the semiconductor light emitting element is effective in forming a wide-band emission spectrum and in enhancing the emission efficiency of an LED or an SLD that are required to have a wide-band emission spectrum, and thus, can acquire, as a light source for an optical coherence tomography apparatus, tomography image information with high resolution in the depth direction of an object. The optical coherence tomography apparatus is useful for tomography imaging in ophthalmology, dentistry, dermatology, and the like.

According to one embodiment of the present invention, a semiconductor light emitting element can be realized in which, by appropriately selecting a band gap of a well layer with regard to each of quantum wells having different well widths of an asymmetric quantum well active layer, an energy band in proximity to the quantum wells is brought close to a flat state, carrier injection into each of the quantum wells is optimized, and the emission efficiency can be improved.

Further, because of the improvement in emission efficiency through the more flat state of the energy band and optimization of carrier injection into the respective quantum wells, intensity of the optical output can be higher than that of a symmetric quantum well active layer including two quantum wells having the larger well width.

By using such an asymmetric quantum well for an active layer of the superluminescent diode (SLD), a highly efficient large output SLD having a wide-band emission spectrum can be realized. Further, the asymmetric quantum well is also effective as an active layer of a high-brightness light emitting diode or a semiconductor optical amplifier (SOA) that are used, similarly to an SLD, with a high injected current density.

Further, by using the above-mentioned semiconductor light emitting element as a light source portion of an optical coherence tomography apparatus, an optical coherence tomography apparatus that enables observation with high resolution in the depth direction can be realized.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. A semiconductor light emitting element, comprising an active layer having a multiple quantum well structure including a first quantum well and a second quantum well having well widths different from each other,
   wherein the first quantum well has a larger well width than the second quantum well and is formed of a material having a wider well layer band gap,
   wherein well layers of the first quantum well and the second quantum well are formed of $In_xGa_{1-x}As$ ($0 \leq x < 1$),
   wherein, when Lw represents a well width of the first quantum well, $In_x(Lw)$ represents a well layer In content of the first quantum well, Ln represents a well width of the second quantum well, and $In_x(Ln)$ represents a well layer In content of the second quantum well,

Lw is 6 nm or more and 10 nm or less, and
Ln is smaller than Lw by 0.1 nm or more, is 1/2 or more of Lw, and is 4.5 nm or more, and
wherein the following Expression (1) is satisfied:

$$0.0631(Ln/Lw)^2 - 0.134(Ln/Lw) + 0.0712 < In_x(Ln) - In_x(Lw)$$

$$< 0.0068(Ln/Lw)^2 - 0.1995(Ln/Lw) + 0.192 \qquad (1).$$

2.  A semiconductor light emitting element, comprising an active layer having a multiple quantum well structure including a first quantum well and a second quantum well having well widths different from each other,
    wherein well layers of the first quantum well and the second quantum well are formed of $Al_xGa_{1-x}As$ ($0 \leq x < 1$),
    wherein the first quantum well is formed of $Al_xGa_{1-x}As$ having a wider band gap than the second quantum well, and
    wherein, when Lw represents a well width of the first quantum well, $Al_x(Lw)$ represents a well layer Al content of the first quantum well, Ln represents a well width of the second quantum well, and $Al_x(Ln)$ represents a well layer Al content of the second quantum well, the following Expression (2) is satisfied:

$$0.0405(Ln/Lw)^2 - 0.0922(Ln/Lw) + 0.0519 < Al_x(Ln) - Al_x(Lw)$$

$$< 0.081(Ln/Lw)^2 - 0.2853(Ln/Lw) + 0.2033 \qquad (2).$$

3.  The semiconductor light emitting element according to claim 1 or 2, wherein each of the first quantum well and the second quantum well comprises a barrier layer formed therein in which an intrinsic quantum level is formed.

4.  The semiconductor light emitting element according to any one of claims 1 to 3, wherein the semiconductor light emitting element comprises one of a light emitting diode, a superluminescent diode, and a semiconductor optical amplification element in which at least a part thereof is used with a high injected current density.

5.  The semiconductor light emitting element according to any one of claims 1 to 4, wherein at least one of the first quantum well and the second quantum well has a structure in which light is emitted from a primary energy level.

6.  A semiconductor light emitting element, comprising a multiple quantum well active layer including a first quantum well and a second quantum well having well widths different from each other,
    wherein the first quantum well has a larger well width than the second quantum well and is formed of a material having a wider well layer band gap,
    wherein well layers of the first quantum well and the second quantum well are formed of $In_xGa_{1-x}As$,
    wherein, when Lw represents a well width of the first quantum well, $In_x(Lw)$ represents a well layer In content of the first quantum well, Ln represents a well width of the second quantum well, and $In_x(Ln)$ represents a well layer In content of the second quantum well,
    Lw is 7 nm or more and 10 nm or less, and
    Ln is smaller than Lw by 0.1 nm or more, is 1/2 or more of Lw, and is 4.5 nm or more, and
    wherein the following Expression (3) is satisfied:

$$-0.6481(Ln/Lw)^3 + 1.7347(Ln/Lw)^2 - 1.5678(Ln/Lw) + 0.4813$$

$$< In_x(Ln) - In_x(Lw) < 0.0836(Ln/Lw)^2 - 0.3212(Ln/Lw) + 0.2357 \qquad (3).$$

7.  The semiconductor light emitting element according to claim 1,
    wherein the active layer further includes a third quantum well,
    wherein the third quantum well has a well width that is equal to or smaller than the well width of the first quantum well and is 4 nm or more,
    wherein a well layer of the third quantum well is formed of $In_xGa_{1-x}As$, and
    wherein a well layer In content of the third quantum well is 0 or more and 0.21 or less.

8.  The semiconductor light emitting element according to claim 6,
    wherein the multiple quantum well active layer further includes a third quantum well,

wherein the third quantum well has a well width that is equal to or smaller than the well width of the first quantum well and is 4 nm or more,

wherein a well layer of the third quantum well is formed of $In_xGa_{1-x}As$, and

wherein a well layer In content of the third quantum well is 0 or more and 0.08 or less.

9. The semiconductor light emitting element according to any one of claims 1 to 8,

wherein the semiconductor light emitting element comprises a superluminescent diode,

wherein the semiconductor light emitting element further comprises a plurality of current injection regions, and

wherein, in a current injection region of the plurality of current injection regions that is on a light exit end side, current injection at a level at which light emission from a primary energy level is dominant is performed, and, in another current injection region of the plurality of current injection regions, current injection at a level at which light emission from a ground state energy level is dominant is performed.

10. The semiconductor light emitting element according to claim 9, wherein the current injection region on the light exit end side is shorter than the another current injection region, and the current injection in the current injection region on the light exit end side is performed at a higher current density than the current injection in the another current injection region.

11. An optical coherence tomography apparatus, comprising:

a light source portion using the semiconductor light emitting element according to any one of claims 1 to 10;

an object measuring portion for radiating light from the light source portion to an object and for transmitting reflected light from the object;

a reference portion for radiating light from the light source portion to a reference mirror and for transmitting reflected light from the reference mirror;

a coherence portion for achieving coherence between reflected light from the object measuring portion and reflected light from the reference portion;

an optical detection portion for detecting coherent light from the coherence portion; and

an image processing portion for acquiring a tomography image of the object based on light detected by the optical detection portion.

# FIG. 1

# FIG. 2

## FIG. 3A

## FIG. 3B

## FIG. 4A

## FIG. 4B

## FIG. 5A

## FIG. 5B

## FIG. 6A

WIDE-WELL: 8 nm (In 0.1 GaAs)

Legend:
- ■ $In_X$-max (Ln) - $In_X$ (8 nm)
- ◆ $In_X$-min (Ln) - $In_X$ (8 nm)
- —— POLYNOMIAL ($In_X$-max (Ln) - $In_X$ (8 nm))
- —— POLYNOMIAL ($In_X$-min (Ln) - $In_X$ (8 nm))

Y-axis: $\Delta In$ CONTENT
X-axis: WELL WIDTH OF SECOND QUANTUM WELL (nm)

## FIG. 6B

WIDE-WELL: 8 nm (In 0.1 GaAs)

$y = 0.27x^2 - 0.6086x + 0.339$

$y = 0.0685x^2 - 0.1548x + 0.0868$

Legend:
- ■ $In_X$-max (Ln) - $In_X$ (8 nm)
- ◆ $In_X$-min (Ln) - $In_X$ (8 nm)
- —— POLYNOMIAL ($In_X$-max (Ln) - $In_X$ (8 nm))
- —— POLYNOMIAL ($In_X$-min (Ln) - $In_X$ (8 nm))

Y-axis: $\Delta In_X$ ($In_X$GaAs)
X-axis: Ln / Lw

## FIG. 7

- ........ 7-7 nm
- – – – 7-6 nm
- ——— 7-5 nm
- –··– 7-4.5 nm

## FIG. 8A

$y = 0.0068x^2 - 0.1995x + 0.192$

$y = 0.0631x^2 - 0.134x + 0.0712$

- ◆ max_(Ln/6)
- ◇ min_(Ln/6)
- △ max_(Ln/10)
- △ min_(Ln/10)
- ● max_(Ln/8)
- ○ min_(Ln/8)
- ✳ max_(Ln/9)
- ⊕ min_(Ln/9)
- ——— POLYNOMIAL (min_(Ln/10))
- ——— POLYNOMIAL (lim-max)

## FIG. 8B

WIDE-WELL: 10 nm (In 0.08 Ga 0.92 As)

$y = 0.2807x^2 - 0.5785x + 0.3013$

$y = 0.4603x^2 - 0.7253x + 0.2837$

$\triangle$ min_(Ln/10)

$\triangle$ max_(Ln/10)

—— POLYNOMIAL (min_(Ln/10))

—— POLYNOMIAL (max_(Ln/10))

## FIG. 8C

WIDE-WELL: 6 nm (In 0.13 Ga 0.87 As)

$y = 0.288x^2 - 0.696x + 0.408$

$y = -0.096x^2 + 0.116x - 0.02$

◆ max_(Ln/6)

◇ min_(Ln/6)

—— POLYNOMIAL (max_(Ln/6))

—— POLYNOMIAL (min_(Ln/6))

FIG. 9

FIG. 10

FIG. 11

## FIG. 12A

WIDE-WELL: 8 nm

- ······ 8-8 nm
- —— 8-7 nm
- - - - 8-5 nm
- —·- 8-4 nm

## FIG. 12B

WIDE-WELL: 7 nm

- ······ 7-7 nm
- —— 7-6 nm
- - - - 7-5 nm
- —·- 7-3.5 nm

# FIG. 13

FIG. 14A

FIG. 14D

FIG. 14B

FIG. 14C

EP 2 950 354 A1

## FIG. 15

- ◆ In$_x$-max(Ln)-In$_x$(8nm)
- ■ In$_x$-min(Ln)-In$_x$(8nm)

## FIG. 16

$$y = 0.0836x^2 - 0.3212x + 0.2357$$

$$y = -0.6481x^3 + 1.7347x^2 - 1.5678x + 0.4813$$

- ◆ max(Ln/9)
- ■ min(Ln/9)
- ▲ max(Ln/7)
- ✕ min(Ln/7)
- ✻ max(Ln/8)
- ● min(Ln/8)
- + max(Ln/10)
- − min(Ln/10)
- —— POLYNOMIAL (max)

## FIG. 17

3RD-WELL WIDTH & 2ND-WELL In CONTENT

Legend:
- ···◆··· 8-7 nm
- —■-- 8-7-6 nm
- -▲- 8-7-8 nm
- ··●·· 8-7-4 nm

X-axis: In CONTENT OF 2ND-WELL (0.09 to 0.15)
Y-axis: OPTICAL OUTPUT (0 to 7)

## FIG. 18

8 nm: In 0.1, 7 nm: In 0.11, 3RD-WELL: $In_x$

Legend:
- ···◆··· $8(0.1)-7(0.11)-6(In_x)$
- —■-- $8(0.1)-7(0.11)-8(In_x)$
- -▲- $8(0.1)-7(0.11)-4(In_x)$

X-axis: In CONTENT OF 3RD-WELL (0 to 0.3)
Y-axis: OPTICAL OUTPUT (0 to 12)

## FIG. 19

3RD-WELL WIDTH & 2ND-WELL In CONTENT

Legend:
- $\cdots\blacklozenge\cdots$ 7(0.11)-6(In$_x$)
- $-\blacksquare-$ 7(0.11)-6(In$_x$)-5(0.0)nm
- $-\blacktriangle-$ 7(0.11)-6(In$_x$)-6(0.0)nm
- $-\times-$ 7(0.11)-6(In$_x$)-4(0.0)nm

## FIG. 20

nm: In0.11, 6nm: In0.12, 3RD-WELL: In$_x$

Legend:
- $\cdots\blacklozenge\cdots$ 7(0.11)-6(0.12)-5(In$_x$)
- $-\blacksquare-$ 7(0.11)-6(0.12)-4(In$_x$)
- $-\blacktriangle-$ 7(0.11)-6(0.12)-6(In$_x$)

## FIG. 21A

## FIG. 21B

## FIG. 22A

## FIG. 22B

## FIG. 23A

SLD_3QW-8(0.1)-7(0.11)-6(0.03)

## FIG. 23B

SLD_3QW-8(0.1)-7(0.11)-8(0.0)

## FIG. 23C

SLD_3QW-8(0.1)-7(0.11)-4(0.05)

## FIG. 24A

8-7-3RD: POWER

8-7-3RD: In$_x$

## FIG. 24B

DEPENDENCE OF 3QW ON 3RD WELL

- - -◆- - - 7-6-3RD: POWER

- - -■- - - 7-6-3RD: In$_x$

## FIG. 25

**EP 2 950 354 A1**

Europäisches Patentamt
European Patent Office
Office européen des brevets

# EUROPEAN SEARCH REPORT

Application Number

EP 15 00 1540

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FR 2 702 602 A1 (DEVEAUD PLEDRAN BENOIT [FR]; REGRENY ANDRE) 16 September 1994 (1994-09-16) | 2-5,9-11 | INV. H01L33/06 H01L33/30 |
| A | * pages 1,2,5-12; figure 8 * ----- | 7,8 | H01S5/343 |
| X | WO 2014/051137 A1 (CANON KK [JP]) 3 April 2014 (2014-04-03) * paragraphs [0001] - [0026], [0034] - [0036], [0039] - [0051]; figures 1-4, 7-12 * ----- | 1,3-11 | ADD. H01L33/00 |

TECHNICAL FIELDS
SEARCHED (IPC)

H01L
H01S

The present search report has been drawn up for all claims

| Place of search | Date of completion of the search | Examiner |
|---|---|---|
| The Hague | 12 October 2015 | Saynova, Desislava |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

35

**ANNEX TO THE EUROPEAN SEARCH REPORT
ON EUROPEAN PATENT APPLICATION NO.**                    EP 15 00 1540

This annex lists the patent family members relating to the patent documents cited in the above-mentioned European search report.
The members are as contained in the European Patent Office EDP file on
The European Patent Office is in no way liable for these particulars which are merely given for the purpose of information.

12-10-2015

| Patent document cited in search report | | Publication date | Patent family member(s) | | Publication date |
|---|---|---|---|---|---|
| FR 2702602 | A1 | 16-09-1994 | NONE | | |
| WO 2014051137 | A1 | 03-04-2014 | JP | 2014082482 A | 08-05-2014 |
| | | | US | 2015263231 A1 | 17-09-2015 |
| | | | WO | 2014051137 A1 | 03-04-2014 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009283736 A